# EUROPÄISCHE PATENTSCHRIFT

(11) **EP 3 005 414 B1**
(45) Veröffentlichungstag und Bekanntmachung des Hinweises auf die Patenterteilung: **26.05.2021**
(21) Anmeldenummer: 14731156.7
(22) Anmeldetag: 05.06.2014
(51) Int. Cl.: H01L 21/67, H01L 21/677

(54) **BEARBEITUNGSANLAGE POLAREN AUFBAUS FÜR PLANARE SUBSTRATE**
PROCESSING SYSTEM HAVING A POLAR STRUCTURE FOR PLANAR SUBSTRATES
INSTALLATION D'USINAGE DE STRUCTURES POLAIRES POUR SUBSTRATS PLANAIRES

(30) Priorität: 06.06.2013 DE 102013009484
(43) Veröffentlichungstag der Anmeldung: 13.04.2016
(73) Patentinhaber: ASYS Automatic Systems GmbH & Co. KG, 73614 Schorndorf (DE)
(72) Erfinder: HÜGLER, Klaus, 73630 Remshalden (DE)
(74) Vertreter: Müller, Gottfried
(86) Internationale Anmeldenummer: PCT/EP2014/001524
(87) Internationale Veröffentlichungsnummer: WO 2014/195019

(56) Entgegenhaltungen:
- WO-A1-00/02228
- JP-A- 2009 218 309
- US-A- 5 981 399
- US-A1- 2004 043 513
- US-A1- 2007 051 314
- US-A1- 2010 173 439
- US-B1- 7 039 499

## Beschreibung

Die Erfindung betrifft eine Bearbeitungsanlage polaren Aufbaus für planare Substrate, wobei die Bearbeitungsanlage ein Basismodul und auf einem Umkreis um dessen zentrale Drehachse gruppierte Prozessstationen aufweist, sowie auch insbesondere in solchen Bearbeitungsanlagen einsetzbare Handhabungsvorrichtungen, Kupplungsanordnungen und/oder Roboter, einschließlich zugehöriger Arbeitsabläufe und/oder Verfahren.

Bearbeitungsanlagen für planare Substrate, wie Wafer, sind häufig mit polar um ein Basismodul gruppierten Prozessstationen aufgebaut (DE 198 31 032 A1). Bestandteil des Basismodules zumindest bei solchen Anlagen, die nicht insgesamt in einem gegen die atmosphärische Umgebung abgegrenzten Reinraum mit auf den Arbeitsprozess abgestimmter Güte untergebracht sind, oder schon aus Größen- und Kostengründen nicht in einer entsprechenden Einhausung unterzubringen sind, ist eine Vakuum-Transferkammer, also eine Transferkammer, die einen Reinraum umschließt, in dem eine gewünschte Reinraumqualität, insbesondere eine auf den jeweiligen Arbeitsprozess abgestimmte Reinraumqualität geschaffen und/oder aufrechterhalten werden kann. In dieser Vakuum-Transferkammer ist zentral eine Handhabungsvorrichtung zur Umsetzung der Wafer zwischen der Vakuum-Transferkammer und den Prozessstationen vorgesehen, die mit ihrer jeweiligen Übergabeöffnung mit der Übergabeöffnung in der Vakuum-Transferkammer, meist steuerbar über eine entsprechende Ventilanordnung, unter Aufrechterhaltung der Abgrenzung gegen die Umgebung fest verbunden sind.

Dieser Grundaufbau ermöglicht bei im Durchmesser kleinen Wafern und in ihrer Grundfläche entsprechend kleinen Prozessstationen häufig die Anordnung einer der Anzahl erforderlicher Bearbeitungsschritte angepassten Mehrzahl von Prozessstationen um ein Basismodul mit kleiner kreisförmiger Grundfläche. Dies ohne Überschneidungen zwischen den Prozessstationen, geringem radialem Abstand zur zentral in der Vakuum-Transferkammer angeordneten Handhabungsvorrichtung und entsprechend kurzen radialen Ausfahrwegen der Handhabungsvorrichtung bei der Umsetzung der Wafer zwischen der Vakuum-Transferkammer und einer jeweiligen Prozessstation. Als Folge sind hohe Arbeitsqualität und hohe Arbeitsgeschwindigkeiten bei guter Beherrschbarkeit der geforderten hohen Positioniergenauigkeit für die jeweils umzusetzenden Wafer gegeben.

Auch aus der US 5,981,399 A ist eine Bearbeitungsanlage polaren Aufbaus für planare Substrate bekannt, bei der eine Vakuum-Transferkammer mit in dieser aufgenommenem Handhabungsgerät vorgesehen ist und bei der zusätzlich über eine zur Vakuum-Transferkammer umschließende Einhausung ein gegen die Umgebungsatmosphäre abgegrenzter Aufnahmeraum geschaffen ist. In diesem Aufnahmeraum liegt zentral zur stationären Einhausung eine drehbare, ihrerseits eine Umfangsbegrenzung aufweisende Vakuum-Transferkammer, wobei im Aufnahmeraum zur Vakuum-Transferkammer über deren Umfangsbegrenzung abgetrennt eine gesonderte Reinraumatmosphäre aufgebaut wird. Die Vakuum-Transferkammer ist zur Einhausung über eine lagefeste Drehachse zentral drehbar gelagert und zwischen Drehlagen verstellbar, in denen das in der drehbaren Vakuum-Transferkammer aufgenommene Handhabungsgerät über eine entsprechende Durchgriffsöffnung in der Einhausung auf eine jeweilige Prozessstation zugreifen kann.

Damit ist auch bei dieser Lösung letztlich über die Größe der Einhausung die Anzahl der mit der Vakuum-Transferkammer über das Handhabungsgerät abgegrenzt zur Umgebungsatmosphäre zu versorgenden Prozessstationen vorgegeben, wobei bei entsprechenden Kupplungseinrichtungen der über Durchgriffsöffnungen zur Einhausung führende Übergangsweg von der Vakuum-Transferkammer auf die jeweilige Prozessstation abgedichtet wird, so dass gewünschte atmosphärische Bedingungen jeweils eingestellt werden können.

Aus der WO 00/02228 A1 ist es im Hinblick auf Kupplungsvorrichtungen im abzusperrenden Übergangsweg von Handhabungsvorrichtungen bei Reinraumanlagen bekannt, hintereinander liegende, nacheinander zu öffnende Sperrabdeckungen vorzusehen, zwischen denen ein Übergabekanal verläuft.

Die US 2004/0043513 A1 zeigt bezogen auf Handhabungsvorrichtungen für Substrate die gleichachsige Anordnung zweier übereinander liegender mehrgelenkiger Greiferarme, die in ihrer Drehlage zu einer gemeinsamen Drehachse sowie in ihrem Abstand längs der Drehachse unabhängig voneinander einstellbar sind.

Weiter ist es aus der JP 2009218309 A bekannt, jeweilige korrespondierende Durchgriffsöffnungen zwischen aneinander anzuschließenden Gehäusen jeweils über einen Deckel zu verschließen und die Deckel, zum gemeinsamen Öffnen, flächig tragfest miteinander zu verbinden und gemeinsam aus dem Öffnungsquerschnitt herauszuheben und quer hierzu zu verlagern.

Schließlich ist der Einsatz mehrarmiger Roboter als Tragvorrichtung für in parallelen Regalen zu lagernden Reinraum-Transportbehältern, insbesondere SMIF-Boxen aus der US 7039499 B1 bekannt. Der Roboter ist hierzu zwischen den Regalreihen platziert und kann die Transportbehälter über den Endeffektor seines in allen Freiheitsgraden frei im Raum verschwenkbaren, mehrgliedrigen Greiferarmes zielgerichtet umsetzen.

Bei Wafern mit größeren Durchmessern, so beispielsweise Wafern mit einem Durchmesser von 400 mm, ergeben sich Prozessstationen mit großer Grundfläche und auch für das Basismodul ergibt sich zur umfangsseitig überschneidungsfreien Andockung einer entsprechenden Anzahl von Prozessmodulen an die Vakuum-Transferkammer ein wesentlich vergrößerter Durchmesser. Damit verbunden sind wesentlich längere radiale Ausfahrwege für die Handhabungsvorrichtung bei der Umsetzung der Wafer zwischen Vakuum-Transferkammer und jeweiliger Prozessstation. Insgesamt ergibt sich so nicht nur ein wesentlich vergrößerter Grundflächenbedarf, sondern der geforderte radiale Ausfahrweg für die Handhabungsvorrichtung führt auch dazu, dass die für die Umsetzung der Wafer geforderte Positioniergenauigkeit zumindest bei den geforderten Geschwindigkeiten allenfalls mit sehr großem Aufwand realisierbar ist.

Durch die Erfindung soll eine Bearbeitungsanlage polaren Aufbaus für planare Substrate aufgezeigt werden, mit der die dargelegten räumlichen Schwierigkeiten und Einschränkungen überwunden werden, so dass sich ein breites Einsatzfeld für unter atmosphärischen Sonderbedingungen durchzuführende Arbeiten insbesondere in der Herstellung elektronischer Elemente, aber auch in der Bio- oder Medizintechnik oder der Analysetechnik ergibt.

Erreicht wird dies mit den Merkmalen des Anspruches 1, zu denen die weiteren Ansprüche zweckmäßige Ausgestaltungen beisteuern, die teilweise auch eigenständige Detaillösungen darstellen.

Erfindungsgemäß ist, aufgrund der weitgehend freien Beweglichkeit der Vakuum-Transferkammer über einer jeweiligen Grundfläche, die Transferkammer in ihrem Durchmesser nicht an den Durchmesser eines Basismoduls gebunden, das seinerseits in seiner Größe und der Größe seiner Grundfläche von der Anzahl der anzudockenden Prozessmodule und von realisierbaren Verfahrwegen der in der Vakuum-Transferkammer aufgenommenen Handhabungsvorrichtung abhängig ist. Aufgrund dieser Entkopplung ergeben sich in der Auslegung der Bearbeitungsanlage Anpassungsmöglichkeiten an jeweilige Gegebenheiten unter Verwendung im Wesentlichen gleicher Bauteile.

Besonders weitgehende Variationsmöglichkeiten sind auch bezüglich der Anzahl der um eine Basisstation anzudockenden Prozessmodule im Rahmen der Erfindung dadurch gegeben, dass die freie Beweglichkeit der Transferkammer im Raum die Nutzung der von der Transferkammer überstrichenen Fläche nicht auf eine Ebene beschränkt, so dass beispielsweise Prozessstationen auch übereinander gestapelt um die jeweilige Grundfläche des Basismodules angeordnet und über die gleiche Vakuum-Transferkammer bedient werden können.

Die freie Beweglichkeit der Vakuum-Transferkammer bietet aber vor allem die Möglichkeit, die Transferkammer und/oder das von dieser aufgenommene Handhabungsgerät so auf die Größe der jeweils anzudockenden Prozessstationen abzustimmen, dass diese Prozessstationen bei minimaler Ausfahrlänge des Handhabungsgerätes über dieses bedient werden können. Damit mögliche relativ kurze Ausfahrwege wirken sich nicht nur auf die möglichen Arbeitsgeschwindigkeiten vorteilhaft aus, sondern ermöglichen vor allen Dingen auch hohe Positioniergenauigkeiten in Verbindung mit einer hinreichend starren, schwingungsfreien Arbeitsweise des Handhabungsgerätes.

Die im Raum frei verschwenkbare Anordnung der Vakuum-Transferkammer über der Grundfläche des Basismodules lässt sich im Rahmen der Erfindung mit einfachen und erprobten Mitteln realisieren, so insbesondere mit einer zum Basismodul zentrischen Drehabstützung, wie sie beispielsweise durch einen Palletierroboter gebildet werden kann, der auch eine entsprechende Hubverstellbarkeit der Vakuum-Transferkammer ermöglicht.

Bei einer derartigen Lösung ist die Vakuum-Transferkammer bevorzugt hängend am galgenartigen Tragarm des als Drehabstützung eingesetzten Palletierroboters angebracht, wobei die Vakuum-Transferkammer zweckmäßigerweise um eine zur Drehachse der Drehabstützung parallele Drehachse drehbar ist, so dass eine Ausrichtung der Vakuum-Transferkammer in ihrer Drehlage auf die jeweils zu beschickende Prozessstation möglich ist.

Um trotz der vielfältigen Bewegungsmöglichkeiten für die Vakuum-Transferkammer die Andocklage zur jeweiligen Prozessstation möglichst feinfühlig erreichen zu können, ist die Vakuum-Transferkammer bevorzugt nicht nur im Raum verlagerbar und um die zur Drehabstützung parallele Drehachse drehbar gehalten, sondern zusätzlich auch zur drehbaren Aufhängung kardanisch verschwenkbar abgestützt, was auch die Möglichkeit eröffnet, im Rahmen der Andockung der Vakuum-Transferkammer diese zur jeweiligen Prozessstation nach Erreichen einer zumindest weitgehend dichten Anschlusslage zur Prozessstation durch Unterdruck saugend gegenüber der Prozessstation zu fixieren.

Um sowohl bezüglich der Vakuum-Transferkammer wie auch der Prozessstationen die jeweils gewünschten, teilweise auch prozessbedingten Reinraumbedingungen bei gegebener Andocklage, wie auch außerhalb der Andockklagen, einstellen und/oder aufrechterhalten zu können, sind den Übergabe- und Durchgriffsöffnungen seitens der Prozessstationen wie auch seitens der Vakuum-Transferkammer absperrbare Kupplungsventile zugeordnet, die bevorzugt jeweils zwei hintereinanderliegende, nacheinander zu öffnende Sperrabdeckungen aufweisen, zwischen denen ein mit einer Druckquelle zu verbindender Übergangsraum liegt.

Ein solcher Übergangsraum bietet die Möglichkeit, trotz des Kontaktes der außenseitigen Teile der Kupplungsventile zu einer gegebenenfalls auch in höherem Maße partikelbelasteten Umgebung, die Gefahr von Verunreinigungen in Verbindung mit dem Kupplungsvorgang zu minimieren.

Hierzu ist primär vorgesehen, dass die jeweils äußere, der Umgebung zugewandte Sperrabdeckung zeitversetzt zur und vor der inneren Sperrabdeckung öffnet und dieser Öffnungsvorgang mit dem Beginn des Zusammenfahrens in die Andocklage zusammenfällt, dass also der Übergangsraum gegen die Umgebung möglichst spät freigegeben wird. Dies in Verbindung damit, dass der Übergangsraum bevorzugt unter Druck gesetzt ist, so dass mit Öffnen dieser Sperrabdeckung der damit verbundene Druckabfall bei weiterem Anschluss des Übergangsraums an eine Druckquelle zu einem Abströmen des Mediums im Übergangsraum in Richtung auf die Umgebung führt, bis durch weiteres Zusammenführen der Kupplungsventile eine zumindest nahezu dichtende Anlage erreicht ist.

Entsprechend der zuvor gegebenen Druckbeaufschlagung, zum Beispiel durch Zuführen, von Spülgas, ist es zur Herstellung eines den Prozessbedingungen entsprechenden Reinraumniveaus in den nun gegeneinander offenen, zusammengefahrenen und einen geschlossenen Durchgriffsweg bildenden Übergangsräumen erfindungsgemäß in mehrfacher Hinsicht vorteilhaft und zweckmäßig, den Durchgriffsweg durch Anschluss an eine Unterdruckquelle, insbesondere eine Vakuumpumpe zu evakuieren.

Hierdurch wird einerseits sichergestellt, dass es zu keiner Verunreinigung der Prozessatmosphäre beim Öffnen der inneren Sperrabdeckungen durch im Durchgriffsweg und in den zu diesem offenen Aufnahmeräumen für die inneren Sperrabdeckungen in deren Öffnungslagen kommt. Zudem werden dadurch, dass aus dem Durchgriffsweg eventuell noch vorhandene Verunreinigungen abgesaugt werden und dadurch im Durchgriffsweg ein entsprechender Unterdruck aufgebaut wird, die Kupplungsventile durch diese Unterdruckbeaufschlagung in eine dichte und die Kupplungsventile quasi starr verbindende Anlagestellung zusammengezogen.

Zweckmäßigerweise wird der sich beim Andocken ergebende Spaltraum zwischen den aufeinander zufahrenden Kupplungsventilen im Rahmen der Erfindung durch eine zu den Kupplungsventilen randseitige, teilweise Umrahmung dadurch zu einem Spülraum, dass die gegeneinander offenen Umrahmungen sich beim Zusammenfahren zunehmend wechselseitig überlappen und dass in den so entstehenden Spülraum ein Spülgas, gegebenenfalls gefilterte Luft eingeblasen wird, durch die auch die äußeren Sperrabdeckungen überblasen und außenseitig gereinigt werden, bevor sie in ihre Öffnungslage überführt werden. Der Spalt-/Spülraum ist bevorzugt gegenüberliegend zum einblasseitigen Bereich, insbesondere in Durchblasrichtung nach unten offen, kann ausblasseitig aber auch zum Beispiel gitterartig ausgebildet sein, so dass sich im Spülraum ein leichter Überdruck gegenüber der Umgebung aufbaut. Durch die nachfolgende Öffnung der äußeren Sperrabdeckungen und den vor dem Öffnen der äußeren Sperrabdeckungen gegebenen Überdruck in den Übergangsräumen ist die Gefahr des Eindringens von Verunreinigungen aus dem Spalt-/Spülraum auf die Übergangsräume vor Zusammenfahren der Kupplungsventile auf ihre Andocklage weitgehend vermieden, so dass mit Erreichen der Andocklage die inneren Sperrabdeckungen geöffnet und der Übergang zwischen Transferkammer und jeweiliger angedockter Prozessstation bei minimierter Gefährdung der für die Durchführung der Prozesse geforderten Reinraumbedingungen freigegeben werden kann, falls weitergehende Reinheitsanforderungen - wie vorstehend angesprochen - nicht zu erfüllen sind.

Die Kupplungsventile liegen im Durchgriffsweg des von der drehbaren Vakuum-Transferkammer aufgenommenen Handhabungsgerätes, das seinerseits zur Vakuum-Transferkammer zentral und drehbar abgestützt ist und bevorzugt eine radial verlaufende Schienenführung-für einen Greiferschlitten aufweist. Der Greiferschlitten bildet den Endeffektor eines mehrarmigen Handlingroboters mit zur Vakuum-Transferkammer zentraler radialer Lagerung, wobei der Handlingroboter bevorzugt als sogenannter Theta-Roboter mit Absicherung gegen Rückschlagen in seiner Umkehrlage ausgebildet ist, so dass hohe Arbeitsgeschwindigkeiten zu realisieren sind. Hierzu trägt auch bei, dass die Vakuum-Transferkammer zumindest einen, bevorzugt mehrere Ablageplätze als Zwischenlagerplätze für Wafer aufweist, zusätzlich einer einer Durchgangsposition zugeordneten Positionierstation, so dass Verlagerungszeiten in der Transferkammer als Rüstzeiten in Vorbereitung auf die Umsetzung der Wafer zwischen Vakuum-Transferkammer und Prozessstation genutzt werden können.

Wie bereits angesprochen, kann eine zentrale Drehabstützung für die frei im Raum verschwenkbare Vakuum-Transferkammer in vorteilhafter Weise durch einen Roboter gebildet sein, insbesondere einen Palletierroboter, dessen Endeffektor durch die von dessen Endarm getragene Vakuum-Transferkammer gebildet ist, die das Handhabungsgerät aufnimmt und eine über ein schaltbares Kupplungsventil absperrbare Übergabe und Durchgriffsöffnung aufweist. Bei der Erfindung bildet somit der Endeffekter des Roboters eine Vakuum-Transferkammer mit umfangsseitiger Durchgriffsöffnung, die zum Endarm des Roboters drehbar und über sich kreuzende Schwenkachsen kardanisch verbunden ist, deren eine, erste Schwenkachse senkrecht zur Ebene der Durchgriffsöffnung und deren andere, zweite Schwenkachse zur Ebene der Durchgriffsöffnung versetzt und parallel verläuft.

Somit ist für eine Bearbeitungsanlage polaren Aufbaus eine zentrale Tragvorrichtung als Teil einer Handhabungsvorrichtung für eine im Raum frei verlagerbare Vakuum-Transferkammer gegeben, die ihrerseits das Handhabungsgerät für die jeweils umzusetzenden Substrate, insbesondere Wafer aufnimmt, so dass sich letztlich die das Basismodul bildenden Elemente als eine bauliche Einheit darstellen, in der alle für die Umsetzung der Substrate auf die Prozessstationen erforderlichen Elemente zusammengefasst sind und die in hohem Maße flexibel - zumindest im Wesentlichen ohne bauliche Veränderungen für Bearbeitungsanlagen unterschiedlicher Größe und mit einer unterschiedlichen Anzahl von Prozessstationen - einzusetzen ist. Dies bei Aufbau der Handhabungsvorrichtung aus grundsätzlich erprobten Bauelementen oder Bausteinen, die in erfinderischer Weise eingesetzt und kombiniert genutzt werden.

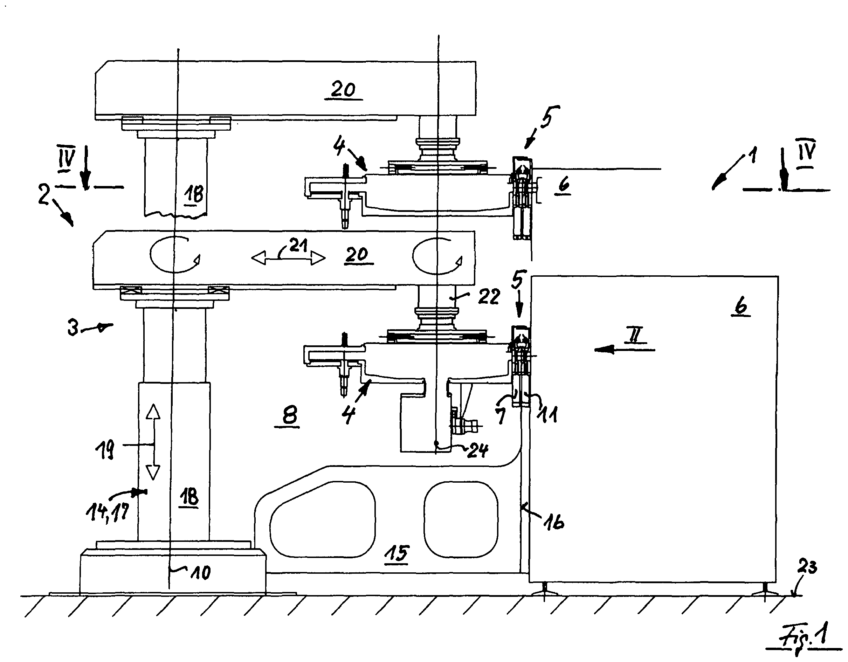

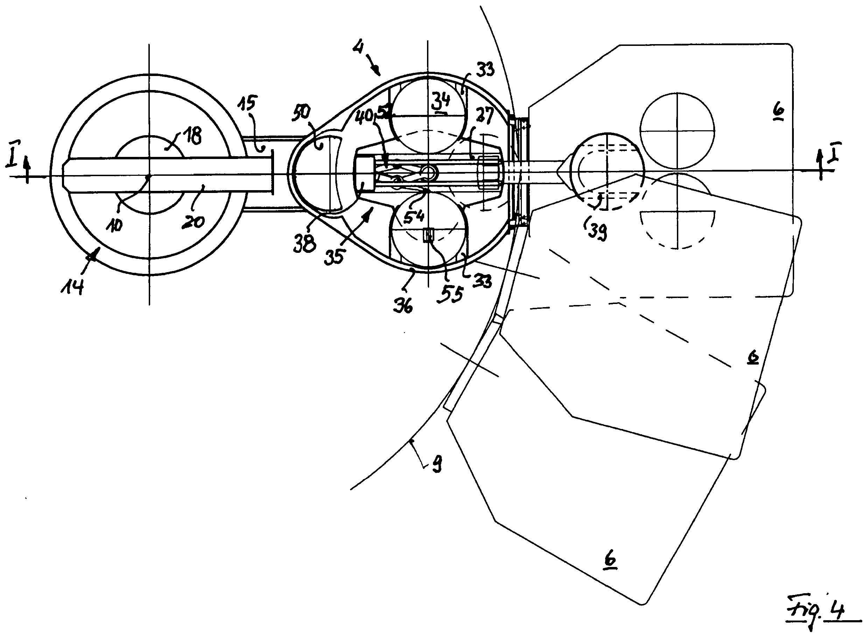

Weitere Einzelheiten und Merkmale der Erfindung ergeben sich aus den Ansprüchen, der nachstehenden Zeichnungsbeschreibung und der schematisierten Zeichnungen. Diese zeigen in
- Fig. 1: in einer vereinfachten Schnittdarstellung gemäß Linie I-I in Fig. 4 eine Teilansicht einer Bearbeitungsanlage polaren Aufbaus für planare Substrate, wobei die Bearbeitungsanlage ein Basismodul, und um dieses zentrale Basismodul gruppierte Prozessstationen aufweist und das Basismodul eine zentrale Drehabstützung und eine über diese zentrale Drehabstützung radial zu deren Drehachse versetzt liegende Vakuum-Transferkammer umfasst, die unter Vermittlung einer Kupplungsanordnung an eine jeweilige Prozessstation anzudocken ist, wobei die Kupplungsanordnung jeweils vorgelagert zu einer Übergabe- und Durchgriffsöffnung mit der Vakuum-Transferkammer und den Prozessstationen verbundene absperrbare Kupplungsventile aufweist,

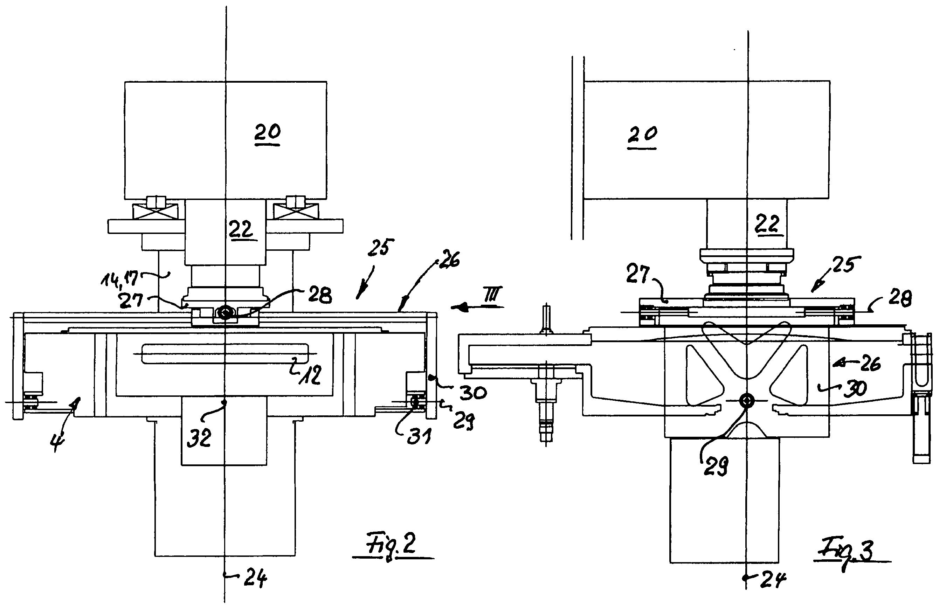

- Fig. 2: eine schematisierte Darstellung der kardanisch verschwenkbaren und drehbaren Verbindung der Vakuum-Transferkammer mit der für diese vorgesehenen Tragvorrichtung, welche entsprechend Fig. 1 durch einen zentral zum Basismodul drehbar angeordneten Palletierroboter als Drehabstützung gebildet ist, an dessen radial zur zentralen Drehachse abgesetzten Endarm die Vakuum-Transferkammer um eine zur zentralen Drehachse parallele Achse drehbar hängend angeordnet ist, in einer vereinfachten Ansicht gemäß Pfeil II in Fig. 1,
- Fig. 3: eine Ansicht der Darstellung gemäß Fig. 2 in Richtung des Pfeiles III in Fig. 2,
- Fig. 4: eine schematisierte und vereinfachte Schnittdarstellung durch die Bearbeitungsanlage gemäß Fig. 1 entsprechend der Schnittführung IV-IV in Fig. 1,

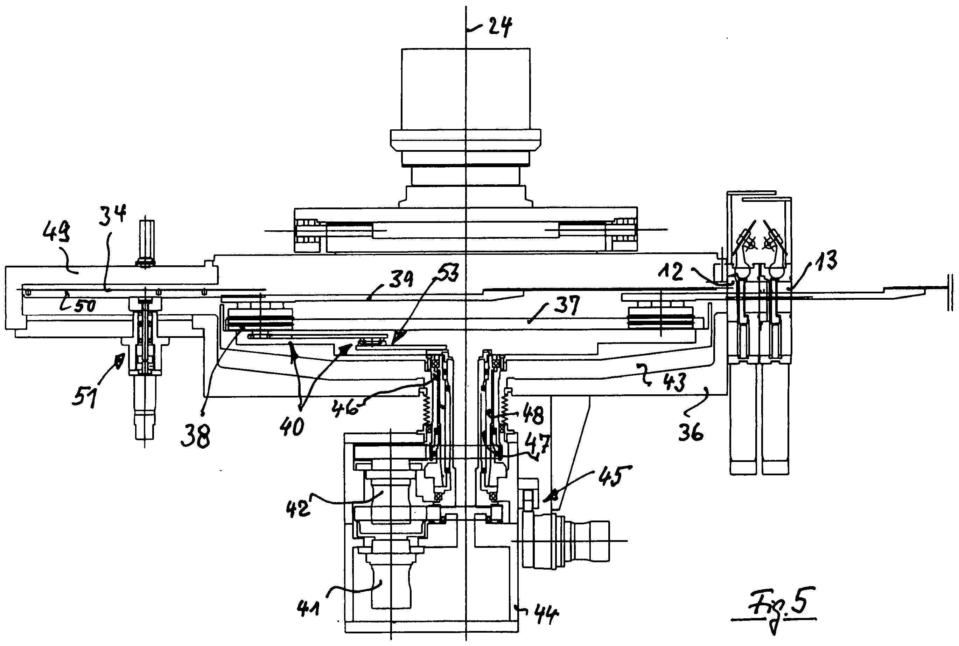

- Fig. 5: eine vereinfachte und vergrößerte Darstellung des Aufbaus der Vakuum-Transferkammer entsprechend der Darstellung in Fig. 1,

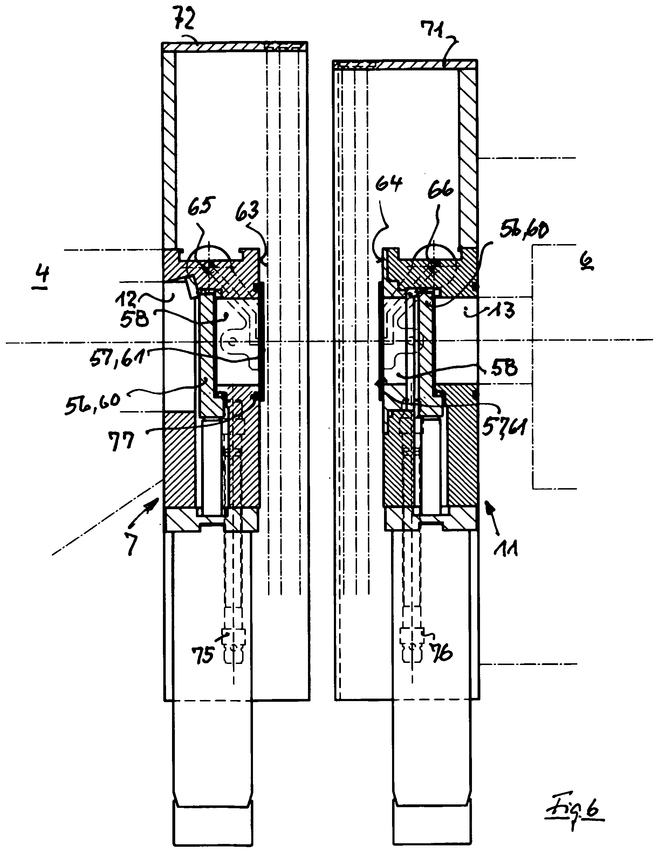

- Fig. 6: bezogen auf eine erste Phase des Andockvorganges der Vakuum-Transferkammer zu dieser Prozessstation, eine Schnittdarstellung der als Übergang zwischen Vakuum-Transferkammer und an diese anzudockender Prozessstation vorgesehenen Kupplungsanordnung mit den zugehörigen Kupplungsventilen, von denen je eines an der Vakuum-Transferkammer und an einer jeweiligen Prozessstation vorgesehen ist, wobei die zusammenzufahrenden Kupplungsventile noch zur Umgebung freiliegen,

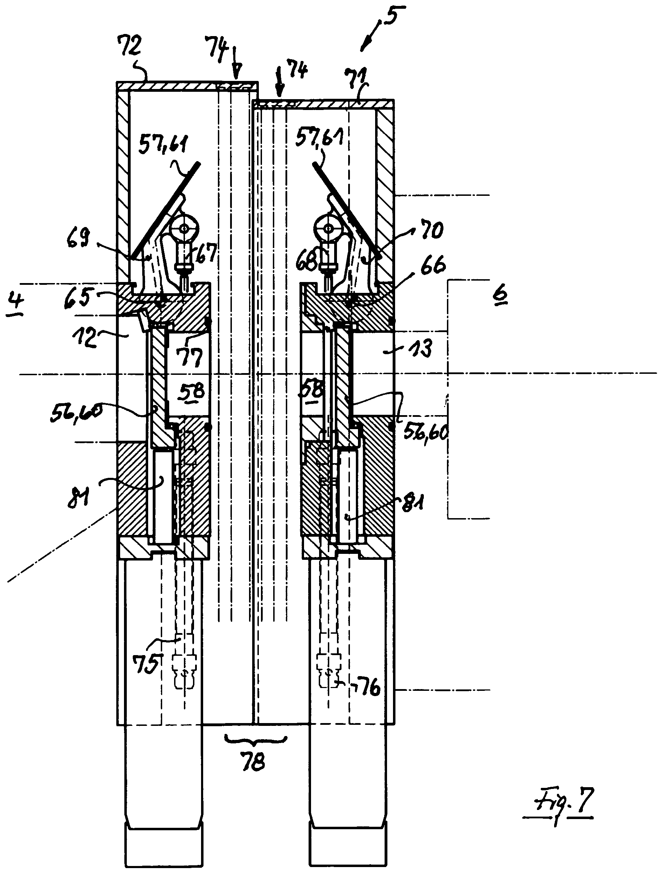

- Fig. 7: eine weitere Phase beim Andockvorgang, in der die Kupplungsventile teilweise bereits über eine umgreifende Abdeckung gegen die Umgebung abgeschirmt sind und deren mit ihren Rücken einander zugewandte Sperrklappen schon in eine Öffnungslage überführt sind, in der sie einen Übergangsraum zwischen einer äußeren und einer inneren Sperrabdeckung des jeweiligen Kupplungsventiles freigeben, der bei jeweils geschlossener Sperrklappe druckbeaufschlagt ist,

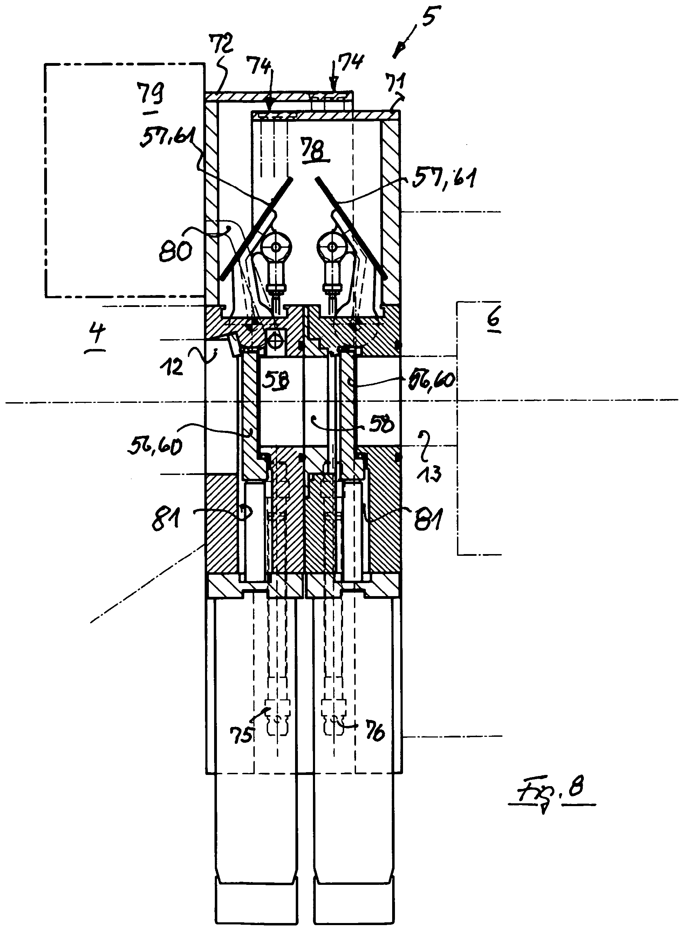

- Fig. 8: die Darstellung einer Phase des Andockvorgangs, bei dem die Kupplungsventile auf ihre Andocklage zusammengefahren sind, so dass deren Übergangsräume einen einheitlichen, im Durchgriffsweg liegenden Raum bilden, der an eine Unterdruckquelle angeschlossen ist, und

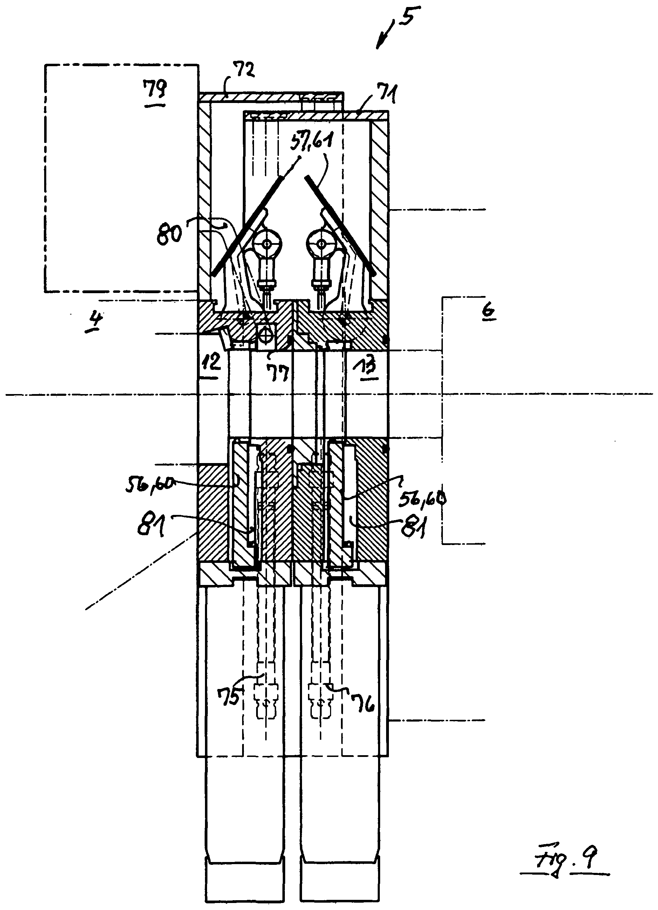

- Fig. 9: eine weitere Darstellung, in der der über die Kupplungsventile führende Durchgriffsweg zwischen Vakuum-Transferkammer und jeweiliger Prozessstation dadurch freigegeben ist, dass nun auch die Sperrschieber in ihre Öffnungslage verfahren sind und in zum Durchgriffsweg offenen Aufnahmeräumen aufgenommen sind.

Fig. 1 zeigt zu einer Bearbeitungsanlage 1 polaren Aufbaus in einer schematisierten Schnittführung gemäß Linie I-I in Fig. 4 eine Handhabungsvorrichtung 2 mit einer Tragvorrichtung 3 und einer über diese getragenen Vakuum-Transferkammer 4. Als Vakuum-Transferkammer ist eine Transferkammer angesprochen, in der auch während des Transfers, bezogen auf die Umgebungsbedingungen, atmosphärische Sonderbedingungen bis hin zu hohen und höchsten Reinheitsklassen aufrechterhalten werden können.

Diese Transferkammer ist über eine Kupplungsanordnung 5 an eine jeweilige Prozessstation 6 angedockt, wobei die Handhabungsvorrichtung 2 mit Tragvorrichtung 3, Vakuum-Transferkammer 4 und, bezogen auf die Darstellungen, einem zur Vakuum-Transferkammer 4 lagefesten Kupplungsventil 7 der Kupplungsanordnung 5 das zentrale Basismodul 8 der Bearbeitungsanlage 1 bilden. Zu diesem Basismodul 8 sind auf einem Umkreis 9 um dessen zentrale Drehachse 10, wie in Fig. 4 angedeutet, eine Reihe von Prozessstationen 6 angeordnet, die, wiederum bezogen auf die Darstellungen, jeweils lagefest mit einem Kupplungsventil 11 versehen sind, das bei zu einer jeweiligen Prozessstation 6 angedockter Vakuum-Transferkammer 4 einen Teil einer Kupplungsanordnung 5 bildet, deren Kupplungsventile 7 und 11 seitens der Vakuum-Transferkammer 4 und der Prozessstationen 6 zu deren Übergabe-/Durchgriffsöffnungen 12 und 13 (Fig. 6 bis 9) umgreifend angeordnet sind und diese in den jeweils nicht angedockten Lagen der Vakuum-Transferkammer 4 zu einer jeweiligen Prozessstation 6 absperren.

Die Darstellung des Basismodules 8 in Fig. 1 veranschaulicht im zentralen Bereich des Basismodules 8, insbesondere zentrisch zum Basismodul 8 eine Drehabstützung 14 achsgleich zur zentralen Drehachse 10, die zu den entlang des Umkreises 9 angeordneten Prozessstationen 6 über radiale Abstützungen 15 lagefest positioniert ist. Die Positionierung entspricht bei zu einer jeweiligen Prozessstation 6 angedockter Vakuum-Transferkammer 4 der zum Umkreis 9 tangentialen Lage der Andockebene 16 zwischen den Kupplungsventilen 7 und 11 der Kupplungsanordnung 5.

Über die Drehabstützung 14 ist die Vakuum-Transferkammer 4 über der Grundfläche des Basismodules 8 frei im Raum verschwenkbar getragen. Die Drehabstützung 4 ist hierzu im Ausführungsbeispiel als Palletierroboter 17 gestaltet, mit einer Tragstütze 18, die in Pfeilrichtung 19 parallel zur Drehachse 10 hubverstellbar ist und die einen radial auskragenden Tragarm 20 trägt, der seinerseits, was nicht gezeigt ist, senkrecht zur Drehachse 10 in Pfeilrichtung 21 in seiner radialen Länge verstellbar sein kann und an dem im von der Tragstütze 18 abgelegenen Endbereich ein Endarm 22 in Richtung auf die Aufstellfläche 23 für das Basismodul 8 auskragend vorgesehen sein kann.

Im Ausführungsbeispiel weist der Tragarm 20 eine vorgegebene Länge auf und es ist der Endarm 22 in Pfeilrichtung 21 radial zur Tragstütze 18 längs des Tragarmes 20 verlagerbar und trägt "hängend" die Vakuum-Transferkammer 4, wobei die Vakuum-Transferkammer 4 mit dem Endarm 22 gegenüber dem Tragarm 20 um eine zur zentralen Drehachse 10 parallele Achse 24 drehbar angetrieben ist oder entsprechend der Drehantrieb zwischen dem Endarm 22 und der hängend daran befestigend Vakuum-Transferkammer 4 vorgesehen ist.

Diese hängende Abstützung ist im Rahmen der Erfindung, wie anhand der Fig. 2 und 3 nachstehend noch näher erläutert, bevorzugt kardanisch gestaltet, so dass bezogen auf die im Rahmen der Erfindung notwendige luftdichte Andockung über die Kupplungsanordnung 5 hinreichende Anpassungsmöglichkeiten gegeben sind, insbesondere auch im Hinblick auf eine Fixierung der Andocklage durch ansaugende Verbindung der aneinander anliegenden Kupplungsventile 7, 11.

Fig. 1 insbesondere in Verbindung mit Fig. 4 veranschaulicht, dass in Abhängigkeit von der Durchmessergröße des Umkreises 9 um das Basismodul 8 Prozessstationen 6 in einer Anzahl in Umfangsrichtung überschneidungsfrei angedockt werden können, die von der Größe der Prozessstationen 6 abhängig ist. Dementsprechend sind diesbezügliche Anpassungsmöglichkeiten schon bei Verwendung gleicher Handhabungsvorrichtungen 2 gegeben, wenn diese bei gegebener Länge des Tragarmes 20 hinreichende radiale Verlagerungsmöglichkeiten für den Endarm 22 in Richtung des Pfeils 21 ermöglichen. In entsprechender Weise könnte der Tragarm 20 seinerseits längenverstellbar gestaltet sein, bei radialer Verstellbarkeit des mit dem Endarm 22 verbundenen äußeren Tragarmteiles. Entsprechende Möglichkeiten sind im Rahmen der Erfindung bei Verwendung, beispielsweise von Knickarmrobotern oder dergleichen, gegeben.

In Verbindung mit der Höhenverstellung der zentrischen Drehabstützung 14 in Richtung des Pfeiles 19 gibt die Erfindung auch die Möglichkeit, Prozessstationen 6, wie in Fig. 1 im oberen Teil veranschaulicht und im Schnitt gemäß Fig. 4 gezeigt, übereinander, auch bei Versatz in Umfangsrichtung des Umkreises 9, anzuordnen und so die Zahl der bezogen auf einen gegebenen Umkreis anordnenbaren Prozessstationen 6 bei gleicher Größe des Basismodules 8 zu vervielfachen.

Fig. 2 und 3 veranschaulichen in einer Ansicht gemäß Pfeil II in Fig. 1 und gemäß Pfeil III in Fig. 2 den grundsätzlichen Aufbau der kardanischen Schwenkverbindung 25 zum um die Drehachse 24 gegenüber dem Tragarm 20 drehbaren Endarm 22.

Die Schwenkverbindung 25 weist einen zur Vakuum-Transferkammer 4 übergreifenden Tragrahmen 26 auf, der die Vakuum-Transferkammer 4 aufnimmt und mit einem Joch 27 über eine Schwenkachse 28 verbunden ist. Das Joch 27 ist mit dem Endarm 22 drehfest verbunden. Die Schwenkachse 28 erstreckt sich senkrecht zur Andockebene 16 und liegt oberhalb der Übergabe-/Durchgriffsöffnung 12. In Hochrichtung versetzt zur Schwenkachse 28 sowie parallel zur Andockebene 16 und unterhalb der Übergabe-/Durchgriffsöffnung 12 liegt die Schwenkachse 29, die durch von den Flanken 30 des Tragrahmens 26 getragene und zur Vakuum-Transferkammer 4 gelagerte Schwenkzapfen 31 bestimmt ist, wobei sich die durch die Schwenkzapfen 31 bestimmte Schwenkachse 29 in Höhe des Schwerpunktes 32 der Vakuum-Transferkammer 4 erstreckt. Diese Art der Aufhängung der Vakuum-Transferkammer 4 gewährleistet in Verbindung mit der Drehbarkeit der Vakuum-Transferkammer 4 um die Drehachse 24 gegenüber dem Tragarm 20 eine einwandfreie Ausrichtung zwischen jeweiliger Prozessstation 6 und der Vakuum-Transferkammer 4, so dass sich in Verbindung mit einer Kupplungsanordnung 5 eine flächige Anlage der Kupplungsventile 7 und 11 ergibt.

Veranschaulicht ist dies auch in den Fig. 4 und 5, wobei Fig. 4 in Verbindung mit der dargestellten Andocklage der Vakuum-Transferkammer 4 zu einer Prozessstation 6 auch die Gruppierung mehrerer Prozessstationen 6 entlang des Umkreises 9 um das Basismodul 8 in möglichen Zugriffslagen durch die im Raum frei schwenkbare Vakuum-Transferkammer 4 zeigt.

Die Vakuum-Transferkammer 4 ist in ihrer Ausgestaltung gemäß dem Ausführungsbeispiel mit zwei Ablagen 33 für flächige Substrate 34 versehen und nimmt des Weiteren ein zu ihrem Gehäuse 36 zentral und drehbar angeordnetes Handhabungsgerät 35 auf, das eine zur mit der Drehachse 24 zusammenfallende Drehachse drehbar ist. Das Handhabungsgerät 35 umfasst des Weiteren eine zur Drehachse 24 radial verlaufende Schienenführung 37 für einen Greiferschlitten 38, der den Endeffektor eines mehrarmigen Handlingroboters 40 bildet. Dieser Handlingroboter 40 ist seinerseits wiederum zentral um die Drehachse 24 drehbar, wobei getrennte Drehantriebe 41 und 42 vorgesehen sind, von denen der Drehantrieb 41 mit dem Handlingroboter 40 verbunden ist und über den Drehantrieb 42 die Schienenführung 37 um die Achse 24 verstellbar ist, wobei die Schienenführung 37 auf einem um die Achse 24 drehbaren und über den Drehantrieb 42 beaufschlagten Drehträger 43 lagefest abgestützt ist. Diese Antriebsverhältnisse sind insbesondere in Fig. 5 schematisiert veranschaulicht, wobei Fig. 5 auch verdeutlicht, dass die Drehantriebe 41, 42 in einem zum Gehäuse 36 der Vakuum-Transferkammer 4 drehfesten, aber axial verlagerbaren Antriebsgehäuse 44 angeordnet sind, das zum Gehäuse 36 über einen Nockentrieb 45 in Richtung der Achse 24 hubverstellbar ist. Durch die Hubverstellung des Antriebsgehäuses 44 ist der Drehträger 43 mit der darauf abgestützten Schienenführung 37 sowie auch synchron hierzu der Handlingroboter 40 hubverstellbar, derart, dass über den Endeffektor 39 die Substrate 34 von den Ablagen 33 abgehoben bzw. auf diesen abgelegt werden können.

Die jeweils erforderliche axiale Drehabstützung des Drehträgers 43 zum Drehantrieb 42 und des Handlingroboters 40 zum Drehantrieb 41 erfolgt über Antriebsbuchsen 46 und 47, zwischen denen eine zum Antriebsgehäuse 44 lagefeste Stützbuchse 48 liegt, zu der die Buchsen 46 und 47 radial und axial lagefest abgestützt sind.

Gegenüberliegend zur Übergabe-/Durchgriffsöffnung 12 ist das Gehäuse 36 der Vakuum-Transferkammer 4 mit einer radial erweiternden Ausbuchtung 49 versehen, in der eine im Zugriffsbereich des Handlingroboters 40 liegende Substratauflage 50 vorgesehen ist, die als Bestandteil einer Positionierstation 51 drehbar ist, so dass das darauf abgelegte Substrat 34 jeweils in die Drehlage versetzt werden kann, die der Bearbeitungsposition des jeweiligen Substrates 34 in der zur angedockten Prozessstation 6 in ihrer Drehlage entspricht.

Fig. 4 veranschaulicht weiter, dass der Handlingroboter als vierarmiges Scherengestänge gemäß Fig. 4 oder auch als zweiarmiges Gelenkgestänge gemäß Fig. 5 ausgebildet werden kann, bei denen über den drehfest mit der Antriebsbuchse 47 verbundenen Gelenkarm und den zum Greiferschlitten 38 angelenkten Arm der Greiferschlitten 38 längs der Schienenführung 37 zu verlagern ist. Endlagen sind, wie in Fig. 4 angedeutet, die in die Vakuum-Transferkammer 4 eingefahrene und die auf die jeweils angedockte Prozessstation 6 ausgefahrene Lage des mit dem Greiferschlitten 38 verbundenen, das jeweilige Substrat 34 tragenden Endeffektors 39. Die einander zur Drehachse 24 gegenüberliegenden Ablagen 33 in der Vakuum-Transferkammer 4 sind durch Drehung des Drehträgers 43 bei in die Vakuum-Transferkammer 4 eingefahrenen Handhabungsgerät 35 zu bedienen, die Substratauflage 50 wird bei aus der gezeigten Endlage teilweise eingefahrenem Greiferschlitten 38 und bezogen auf die Darstellung gemäß Fig. 4 über ein 180° verdrehtem Drehträger 43 erreicht. Bezogen auf das gezeigte Ausführungsbeispiel mit drei innerhalb der Vakuum-Transferkammer 4 angeordneten Ablagen 33 und 50, von denen über der Ablage 50 zusätzlich eine Positionierung des jeweils abgelegten Substrates in seiner Winkellage möglich ist, sind Prozessstationen 6 mit jeweils drei Ablagen unter Beibehalt der jeweiligen Andocklage zu beschicken, so dass sich hohe Arbeitsgeschwindigkeiten erreichen lassen.

Um bei damit verbundenen hohen Arbeitsgeschwindigkeiten des Handhabungsgerätes 35 und gegebenenfalls zu Drehungen des Drehträgers 43, und damit auch der Schienenführung 37 überlagerten Axialverlagerungen des Greiferschlittens 38 über das Scherengestänge 52 gemäß Fig. 4 oder Gelenkgestänge 53 gemäß Fig. 5 beim Durchfahren von dessen zusammengeschwenkter Totpunktlage ein Umschlagen auf die der jeweiligen Vorschubrichtung entgegengesetzte Richtung zu vermeiden, ist, wie in Fig. 4 angedeutet, bevorzugt der, oder einer der am Greiferschlitten 38 angelenkten Arme über seinen Gelenkpunkt zum um die Drehachse 24 schwenkbarem Arm hinaus verlängert, wobei diese Verlängerung einen dornartigen Fortsatz 54 bildet, der bei der Ausfahrbewegung des Greiferschlittens 38 im Bereich von dessen axialer, zur Drehachse 24 benachbarter Mittellage und entsprechend zusammengeklapptem Gestänge 52, 53 in eine trichterförmige Schiebeführung 55 eintaucht, womit beim Durchlaufen der Totpunktlage des Gestänges 52, 53 eine Rückschlagbewegung desselben ausgeschlossen wird.

Durch die Gestaltung des Basismodules 8 mit frei im Raum verschwenkbar getragener Vakuum-Transferkammer 4 ergeben sich grundsätzlich im Aufbau der Bearbeitungsanlage bezüglich der wechselseitigen Abstimmung der Anlagenkomponenten in ihrer Lage zueinander größere Freiheiten. Ist die Bearbeitungsanlage allerdings nicht in einem Rein- oder Reinstraum angeordnet, so bedeutet die freie Beweglichkeit der Vakuum-Transferkammer 4 im Raum auch, dass ungeachtet von der Vakuum-Transferkammer und den Prozessstationen seitens der Übergabe-/Durchgangsöffnungen zugeordneter Abdeckungen beim zum Andocken notwendigen Öffnen dieser Abdeckungen Verunreinigungen in den Übergangsweg zwischen Vakuum-Transferkammer 4 und Prozessstation 6 gelangen und damit den geforderten Reinheitsgrad der jeweiligen Arbeitsatmosphäre beeinträchtigen.

Dies wird erfindungsgemäß durch die Verwendung einer Kupplungsanordnung 5 vermieden, die in gasdichter und lagefester Zuordnung zur Vakuum-Transferkammer 4 und zur jeweils anzudockenden Prozessstation 6 vorgelagert zur jeweiligen Übergabe-/Durchgangsöffnung 12, 13 ein Kupplungsventil 7, 11 vorsieht. In der Andocklage der Vakuum-Transferkammer 4 zu einem jeweiligen Prozessmodul 6 schließen die Kupplungsventile 7, 11 in einer Andockebene 16 gasdicht aneinander an. Zudem sind die Kupplungsventile 7, 11 jeweils vorgelagert zur seitens der Vakuum-Transferkammer 4 und des Prozessmodules 6 vorgesehenen Übergabe-/Durchgriffsöffnungen 12, 13 mit im Durchgangsweg beabstandet zueinander liegenden und nacheinander zu öffnenden Sperrabdeckungen 56, 57 versehen, zwischen denen jeweils ein Übergangsraum 58 liegt. Von den Sperrabdeckungen 56, 57 ist im gezeigten Ausführungsbeispiel (siehe insbesondere Fig. 6 bis 9) die jeweils innere, also zum Innenraum der Vakuum-Transferkammer 4 bzw. zum Innenraum des Prozessmodules 6 sperrende Abdeckung als Sperrschieber 60 ausgebildet, der über eine Stellvorrichtung, bevorzugt einen fluidischen Stellzylinder zwischen seiner Sperrlage zur Übergabe-/Durchgangsöffnung 12, 13 und einer Öffnungslage verstellbar ist. Nach der Gegenseite ist der Übergangsraum 58 jeweils über eine Sperrklappe 61 abzusperren, die bevorzugt aufsetzend auf die Andockfläche 63, 64 des jeweiligen Kupplungsventiles 7, 11 die Verbindung des Übergangsraumes 58 zur Umgebung absperrt. Die Sperrklappen 61 sind im Ausführungsbeispiel jeweils um zur Andockfläche 63, 64 parallel liegende Achsen 65, 66 und über Stellzylinder 67, 68 verschwenkbar, die sich etwa in der gleichen Ebene wie die den Sperrschiebern 60 zugeordneten Stellzylinder 75, 76 erstrecken.

Der zwischen den Sperrabdeckungen 56, 57 eingeschlossene Übergangsraum 58 beider Kupplungsventile 7 und 11 ist bei geschlossenen Sperrabdeckungen 56, 57 jeweils druckbeaufschlagt, bevorzugt mit Reinluft oder einem Sperrgas, so dass der Übergangsraum 58 beim Öffnen der Sperrklappen 61 zumindest weitgehend frei von Verunreinigungen gehalten ist. Die Druckzuführung auf den Übergangsraum 58 ist in Fig. 7 und 8 strichliert angedeutet und erfolgt bevorzugt über die Drehachsen 65, 66 der die Sperrklappen 61 tragenden Stützarme 69, 70.

Zunächst liegen die Kupplungsventile 7 und 11, bevor der eigentliche Andockprozess beginnt, zur Umgebung frei, wie in Fig. 6 veranschaulicht. Im Weiteren werden die Kupplungsventile 7 und 11 weiter zusammengefahren (Fig. 7), wobei die Sperrklappen 61, um Überschneidungen zu vermeiden, während dieser Andockphase, in der die Kupplungsventile 7, 11 in Richtung auf die gemeinsame Andockebene 16 durch Verlagerung der Vakuum-Transferkammer 4 zusammengefahren werden, zeitversetzt geöffnet werden. In dieser Phase kommen die Kupplungsventile 7, 11 über über deren Andockflächen 63, 64 gegeneinander auskragende und die Kupplungsventile 7, 11 teilweise umschließende Wandteile 71, 72 in wechselseitige Überdeckung. Hierdurch wird ein kanalartiger Durchströmungsbereich geschaffen und dieser Durchströmungsbereich bildet bei entsprechender Spülluftzuführung, wie über die Pfeile 74 angedeutet, einen nach unten offenen Spülkanal 78 (Fig. 7), so dass auch etwa an den Sperrklappen 61 anhaftende Partikel vor dem Öffnen der Sperrklappen 61 schon weitgehend abgetragen sind. Werden die Sperrklappen 61 anschließend geöffnet, bei weiterem Zusammenfahren der Kupplungsventile 7, 11 auf ihre gemeinsame Andockebene 16, so ist der zwischen den sich aneinander annähernden Kupplungsventilen 7, 11 liegende Übergangsraum 58 durch den vorherigen Druckaufbau in diesen gegen das Eindringen von Verunreinigungen geschützt. Erreichen die Kupplungsventile 7, 11 durch Zusammenfahren ihrer Andockflächen 63, 64 die Andockebene 16, so liegen die Kupplungsventile 7, 11 dichtend aneinander an, wobei der Übergangsweg zwischen den Übergabe-/Durchgriffsöffnungen 12, 13 in der Andockebene zudem über eine umschließende Dichtung 77, zum Beispiel einen Dichtring, gegen die Umgebung abgesperrt ist, über den die Sperrklappe 61 der Sperrabdeckung 57 in ihrer Schließlage zur Andockfläche 63 abgedichtet ist.

In dieser in Fig. 8 veranschaulichten Phase des Andockvorgangs werden die nun zu einem einheitlichen Raum verbundenen Übergangsräume 58 an eine Unterdruckquelle 79, zum Beispiel eine Vakuumpumpe, über die schematisiert angedeutete Leitungsverbindung 80 angeschlossen, wodurch eventuell noch vorhandene Partikel vor Freigabe des Übergangs zwischen Vakuum-Transferkammer 4 und jeweiliger Prozessstation 6 abgesaugt werden und auch die Kupplungsventile 7 und 11 in dichtende Anlage zueinander gezogen werden. Im Anschluss daran werden zur Freigabe der nun zumindest weitgehendst Reinraumbedingungen genügenden Übergangsverbindung die Sperrschieber 60 geöffnet und hierzu in die mit den Übergaberäumen 58 verbundenen Aufnahmeräume 81 eingefahren.

Ungeachtet einer im Raum freien Verlagerbarkeit der Vakuum-Transferkammer 4 auch in verunreinigten Arbeitsumgebungen kann auf die erfindungsgemäße Weise und mit dem erfindungsgemäßen Kupplungssystem erreicht werden, dass die jeweils für die Vakuum-Transferkammer 4 und/oder die anzudockenden Prozessstationen 6 vorgegebenen Arbeitsatmosphären bis hin zu hohen und höchsten Reinheitsklassen bei Andockvorgängen zumindest nicht wesentlich beeinträchtigt werden, trotz der aufgelösten Bauweise, also ein durch Verunreinigungen nicht beeinträchtigtes Arbeiten der Bearbeitungsanlage möglich ist, auch wenn diese nicht in einer geschützten Atmosphäre aufgestellt ist.

## Patentansprüche

1. Bearbeitungsanlage polaren Aufbaus für planare Substrate,
o mit einem zentralen Basismodul (8) mit einer Vakuum-Transferkammer (4) für die Substrate (34),
o mit zum Basismodul (8) polar angeordneten, umfangsseitig an die Vakuum-Transferkammer (4) zur Umgebung des Basismoduls (8) abgrenzend anzuschließenden Prozessstationen (6),
∘ mit einem von der Vakuum-Transferkammer (4) aufgenommenen Handhabungsgerät (35) für die Substrate (34),
∘ mit einer im zentralen Bereich des Basismoduls (8) liegenden, zentrischen Drehabstützung (14), und
∘ mit in Anschlusslagen zu den von der Drehabstützung (14) radial beabstandeten, um das Basismodul (8) gruppierten Prozessstationen (6) dichtend angeschlossen zu positionierender Vakuum-Transferkammer (4),
wobei die Vakuum-Transferkammer (4) eine vom Handhabungsgerät (15) durchgreifbare, über ein schaltbares Kupplungsventil absperrbare Durchgriffsöffnung (12) aufweist,
**dadurch gekennzeichnet,**
**dass** die Vakuum-Transferkammer (4) über die zentrische Drehabstützung (14) exzentrisch zum Basismodul (8) radial und höhenverstellbar frei im Raum verschwenkbar getragen ist.

2. Bearbeitungsanlage nach Anspruch 1,
**dadurch gekennzeichnet,**
**dass** die radial zur Drehabstützung (14) versetzte Vakuum-Transferkammer (4) um eine zur Drehabstützung (14) parallele Drehachse (24) drehbar ist.

3. Bearbeitungsanlage nach Anspruch 1 oder 2,
**dadurch gekennzeichnet,**
**dass** die Vakuum-Transferkammer (4) zu einem Endarm (22) der Drehabstützung (14) kardanisch verschwenkbar abgestützt ist.

4. Bearbeitungsanlage nach Anspruch 1,
**dadurch gekennzeichnet,**
**dass** das Kupplungsventil (7) im Durchgriffsweg des Handhabungsgerätes (35), zur Durchgriffsöffnung (12) nachgeordnet, zwei hintereinanderliegende, nacheinander zu öffnende Sperrabdeckungen (56, 57) aufweist, zwischen denen ein mit einer Druckquelle verbundener, druckbeaufschlagter Übergangsraum (58) liegt.

## Claims

1. Processing system having a polar structure for planar substrates,
∘ having a central base module (8) with a vacuum transfer chamber (4) for the substrates (34),
∘ having process stations (6) which are arranged in a polar manner with respect to the base module (8) and are to be connected circumferentially to the vacuum transfer chamber (4) so as to provide a delimitation with respect to the surroundings of the base module (8),
∘ having a handling device (35) for the substrates (34) accommodated by the vacuum transfer chamber (4),
∘ having a central rotary support (14) lying in the central region of the base module (8), and
∘ having a vacuum transfer chamber (4) which is to be positioned in a sealingly connected manner in connection positions with respect to the process stations (6), which are spaced apart radially from the rotary support (14) and are grouped around the base module (8),
wherein the vacuum transfer chamber (4) has a passage opening (12) through which the handling device (15) can reach and which can be shutoff via a switchable coupling valve,
**characterized**
**in that** the vacuum transfer chamber (4) is carried eccentrically with respect to the base module (8) via the central rotary support (14) so as to be radially and height-adjustably freely pivotable in space.

2. Processing system according to Claim 1,
**characterized**
**in that** the vacuum transfer chamber (4) which is offset radially with respect to the rotary support (14) is rotatable about an axis of rotation (24) parallel to the rotary support (14).

3. Processing system according to Claim 1 or 2,
**characterized**
**in that** the vacuum transfer chamber (4) is supported in a cardanically pivotable manner with respect to an end arm (22) of the rotary support (14).

4. Processing system according to Claim 1,
**characterized**
**in that** the coupling valve (7) in the passage path of the handling device (35), downstream of the passage opening (12), has two shut-off covers (56, 57) which lie one behind the other, are to be opened one after the other and between which a pressurized transition compartment (58) that is connected to a pressure source is located.

## Revendications

1. Système de traitement à structure polaire destiné à des substrats planaires, ledit système comprenant
∘ un module de base central (8) pourvu d'une chambre de transfert sous vide (4) destinée aux substrats (34),
∘ des stations de traitement (6) qui sont disposées de manière polaire par rapport au module de base (8) et qui sont destinées à être raccordées circonférentiellement à la chambre de transfert sous vide (4) de manière adjacente à l'environnement du module de base (8),
∘ un dispositif de manipulation (35) des substrats (34) reçus par la chambre de transfert sous vide (4),
∘ un support rotatif central (14) situé dans la zone centrale du module de base (8), et
∘ une chambre de transfert sous vide (4) à positionner qui est raccordée de manière étanche, à des positions de raccordement, aux stations de traitement (6) qui sont espacées radialement du support rotatif (14) et qui sont regroupées autour du module de base (8),
la chambre de transfert sous vide (4) comportant une ouverture d'accès (12) qui est accessible par le dispositif de manipulation (15) et qui peut être fermée par une soupape d'accouplement commutable,
**caractérisé en ce que**
la chambre de transfert sous vide (4) est supportée de manière excentrique par rapport au module de base (8) par le support rotatif central (14) afin de pouvoir pivoter librement dans l'espace de manière réglable verticalement et radialement.

2. Système de traitement selon la revendication 1,
**caractérisé en ce que**
la chambre de transfert sous vide (4), décalée radialement par rapport au support rotatif (14), peut être mise en rotation sur un axe de rotation (24) parallèlement au support rotatif (14).

3. Système de traitement selon la revendication 1 ou 2,
**caractérisé en ce que**
la chambre de transfert sous vide (4) est supportée de manière pivotante à Cardan par rapport à un bras d'extrémité (22) du support rotatif (14).

4. Système de traitement selon la revendication 1,
**caractérisé en ce que**
la soupape d'accouplement (7) comporte dans le chemin d'accès du dispositif de manutention (35), en aval de l'ouverture d'accès (12), deux couvercles de blocage (56, 57), situés l'un derrière l'autre, qui peuvent être ouverts l'un après l'autre et entre lesquels est ménagé un espace de transition sous pression (58) relié à une source de pression.
